# EUROPÄISCHE PATENTANMELDUNG

(11) **EP 4 563 352 A1**
(43) Veröffentlichungstag der Anmeldung: **04.06.2025**
(21) Anmeldenummer: 23213247.2
(22) Anmeldetag: 30.11.2023
(51) Int. Cl.: B41F 27/00, B41C 1/10, B41F 27/12

(54) **ANLAGE ZUM BEREITSTELLEN BELICHTETER UND ABGEKANTETER DRUCKPLATTEN**

(71) Anmelder: Heidelberger Druckmaschinen AG, 69115 Heidelberg (DE)
(72) Erfinder: Huyghe, Hans, 9772 Wannegem-Lede (BE); Becker, Volker, 69231 Malschenberg (DE); Zehms, Hans-Jürgen, 24113 Kiel (DE); Ringle, Ingo, 69214 Eppelheim (DE); Schelble, Klaus, 24103 Kiel (DE)

(57) **Zusammenfassung**

Eine erfindungsgemäße Anlage zum Bereitstellen belichteter und abgekanteter Druckplatten, welche folgende Module aufweist: wenigstes ein Belademodul (10), welches eine Vorrichtung (11) zum Bevorraten und Zuführen von unbelichteten Druckplatten (2) umfasst; ein Belichtungsmodul (20), welches eine Vorrichtung (21) zum Belichten von zugeführten Druckplatten (2) umfasst; und ein Abkantmodul (30), welches eine Vorrichtung (31) zum Abkanten von belichteten Druckplatten (2) umfasst, zeichnet sich dadurch aus, dass das Abkantmodul (30) und das Belademodul (10) oder eines der Belademodule (10) derart zu einem Kombimodul (40) zusammengefasst sind, dass die Vorrichtung (31) zum Abkanten von belichteten Druckplatten (2) auf der Vorrichtung (11) zum Bevorraten und Zuführen von unbelichteten Druckplatten (2) angeordnet ist. Die Erfindung ermöglicht es in vorteilhafter Weise, Belichter-Anlagen platzsparend zu verwirklichen. Die Erfindung kommt bevorzugt in der grafischen Industrie und insbesondere im sogenannten Prepress-Bereich (Druckvorstufe) zum Einsatz.

## Beschreibung

Die Erfindung betrifft eine Anlage zum Bereitstellen belichteter und abgekanteter Druckplatten mit den Merkmalen des Oberbegriffs von Anspruch 1.

### Gebiet der Technik

Die Erfindung liegt auf dem technischen Gebiet der grafischen Industrie und dort insbesondere im Bereich des Herstellens von belichteten Druckplatten, wie z.B. Offsetdruckplatten, sowie des Abkantens belichteter Druckplatten, um diese für das Abdrucken auf Druckzylinder aufziehen und spannen zu können.

### Stand der Technik

Die EP0985528A1, die DE202007011576U1, die US6354208B1 und die US8256348B1 offenbaren Anlagen für das Belichten von Druckplatten und für das Weiterverarbeiten der belichteten Druckplatten, insbesondere das Abkanten.

Die US7225737B2 offenbart ein Verfahren zum automatisierten Herstellen von Druckplatten, wobei Druckplatten in einem Belichter belichtet und anschließend abgekantet werden. Das Abkanten findet ebenfalls in dem Belichter statt bzw. die dafür vorgesehene Abkantvorrichtung ist einer Vorrichtung zum Belichten benachbart angeordnet.

Die EP3564036A1 offenbart ein Verfahren zum Belichten und automatischen Sortieren von Druckplatten.

Industriell genutzte Anlagen für das hochproduktive und -qualitative Belichten, Abkanten und für mögliche weitere Schritte der Druckplattenbehandlung können aufgrund ihrer Ausmaße viel Stellfläche fordern. In bestehenden Druckproduktionsstätten ist diese Stellfläche gegebenenfalls nicht vorhanden oder muss aufwändig geschaffen werden. Das Einsparen von Stellfläche ist daher mit Vorteilen verbunden und kann den Markterfolg einer solchen Anlage positiv beeinflussen.

### Technische Aufgabe

Es ist daher eine Aufgabe der vorliegenden Erfindung, eine Verbesserung gegenüber dem Stand der Technik zu schaffen, welche es insbesondere ermöglicht, Belichter-Anlagen platzsparend zu verwirklichen.

### Erfindungsgemäße Lösung der Aufgabe

Diese Aufgabe wird erfindungsgemäß durch eine Anlage nach Anspruch 1 gelöst.

Vorteilhafte und daher bevorzugte Weiterbildungen der Erfindung ergeben sich aus den Unteransprüchen sowie aus der Beschreibung und den Zeichnungen.

Eine erfindungsgemäße Anlage zum Bereitstellen belichteter und abgekanteter Druckplatten, welche folgende Module aufweist: wenigstes ein Belademodul, welches eine Vorrichtung zum Bevorraten und Zuführen von unbelichteten Druckplatten umfasst; ein Belichtungsmodul, welches eine Vorrichtung zum Belichten von zugeführten Druckplatten umfasst; und ein Abkantmodul, welches eine Vorrichtung zum Abkanten von belichteten Druckplatten umfasst, zeichnet sich dadurch aus, dass das Abkantmodul und das Belademodul oder eines der Belademodule derart zu einem Kombimodul zusammengefasst sind, dass die Vorrichtung zum Abkanten von belichteten Druckplatten auf der Vorrichtung zum Bevorraten und Zuführen von unbelichteten Druckplatten angeordnet ist.

### Vorteilhafte Ausbildungen und Wirkungen der Erfindung

Die Erfindung ermöglicht es in vorteilhafter Weise, Belichter-Anlagen platzsparend und damit ggf. kostengünstiger zu verwirklichen. Die Erfindung kommt bevorzugt in der grafischen Industrie und insbesondere im sogenannten Prepress-Bereich (Druckvorstufe) zum Einsatz.

Das erfindungsgemäße Bereitstellen und Einsetzen eines Kombimoduls spart Bodenfläche in der Produktionsstätte. Das Kombimodul kann dabei das Belademodul und das Abkantmodul durch einfaches Übereinanderanordnen zusammenfassen; alternativ können das Belademodul das Abkantmodul integriert werden und eine neue Einheit bilden.

Das Belademodul des Kombimoduls kann die bevorrateten Druckplatten in Kassetten aufnehmen, d.h. als sogenannter "Cassette Loader" (eine Kassette) oder "Dual Cassette Loader" (zwei - oder auch mehr - Kassetten) ausgebildet sein. Alternativ kann das Belademodul die bevorrateten Druckplatten auf einer Palette aufnehmen, d.h. als sogenannter "Pallet Loader" ausgebildet sein.

In der Druckvorstufe sind folgende einzelne Module bereits bekannt (allerdings platzraubend hintereinander aufgereiht als sogenannte "Straße"): Belademodul (loading module, loader), Belichtungsmodul (imaging module, Belichter, CtP), Abkantmodul (bending module), Speichermodul (stacking module) und ggf. Sortiermodul (sorting module). Darüber hinaus ist auch ein Entwicklungsmodul (developing module) in solchen "Straßen" bereits bekannt, sofern keine prozesslosen Druckplatten verarbeitet werden. Die Erfindung ist demgegenüber besonders vorteilhaft im Umfeld der Verarbeitung von prozesslosen Druckplatten einsetzbar, da solche Platten nicht chemisch entwickelt werden müssen (d.h. auf das Entwicklungsmodul somit verzichtet werden kann) und eine erzeugte Abkantung ist daher weniger oder nicht störend in Folgeschritten.

Obgleich das Kombimodul ein Abkantmodul umfasst, muss dessen Abkantvorrichtung nicht bei jeder Anwendung aktiv werden. Vielmehr kann von Druckplatte zu Druckplatte rechentechnisch entschieden werden, ob eine Abkantung erzeugt werden muss oder nicht. Hierzu kann zum Beispiel ein Barcode o.ä. auf der Druckplatte erfasst und hinsichtlich der Notwendigkeit für eine Abkantung ausgewertet werden. Alternativ hierzu können notwendige Daten von der Vorstufen-Software bereitgestellt werden.

Die Druckplatten können vor dem Abkanten oder nach dem Abkanten um gewisse vorgegebene Strecken parallel zur Abkantung verschoben werden, sodass die Druckplatten später beim Speichern kaskadiert aufeinander aufgelegt werden können. Dies erleichtert die Entnahme einzelner Druckplatten oder mehrerer Druckplatten eines gemeinsamen Druckauftrages aus dem Speichermodul.

Die Abkantvorrichtung kann einen Anschlag aufweisen, an welchen die zu bearbeitenden Druckplatten nacheinander herangefördert werden. Eine am Anschlag anliegende Druckplatte kann mit einem Abkantwerkzeug, welches bevorzugt von oben wirkt, mit einer vorgegebenen Abkantung (bevorzugt nach unten) versehen werden. Nach erfolgtem Abkanten kann die Druckplatte ausgegeben oder an eine Folgestation übergeben werden. Hierzu kann die Druckplatte bevorzugt unter der Abkantvorrichtung hindurch, durch diese hindurch oder an dieser vorbei bewegt werden.

Sofern ein Speichermodul vorgesehen ist, ist dieses bevorzugt derart ausgebildet, dass es abgekantete Druckplatten aufnehmen kann, z.B. in einer entsprechenden Ausnehmung oder einem Schacht des Speichermoduls.

Bei den zu bearbeitenden Druckplatten handelt es sich bevorzugt um Offset-Druckplatten. Diese kommen bevorzugt in bogenverarbeitenden Druckmaschine zum Einsatz, z.B. im Akzidenzdruck oder Verpackungsdruck; alternativ können diese in Rollendruckmaschinen, z.B. in Zeitungsdruckmaschinen, zum Einsatz kommen.

### Weiterbildungen der Erfindung

Im Folgenden werden bevorzugte Weiterbildungen der Erfindung (kurz: Weiterbildungen) beschrieben. Diese können - wo es sich nicht technisch ausschließt - auch untereinander kombiniert werden.

Eine Weiterbildung kann sich dadurch auszeichnen, dass die unbelichteten Druckplatten dem Belichtungsmodul von dem Belademodul in einer Zuführrichtung zugeführt werden. Eine Weiterbildung kann sich dadurch auszeichnen, dass die belichteten Druckplatten von dem Belichtungsmodul in einer Ausgaberichtung ausgegeben werden. Eine Weiterbildung kann sich dadurch auszeichnen, dass die Ausgaberichtung entgegen der Zuführrichtung orientiert ist. Eine Weiterbildung kann sich dadurch auszeichnen, dass die Ausgaberichtung mit der Zuführrichtung orientiert ist.

Eine Weiterbildung kann sich dadurch auszeichnen, dass die Vorrichtung zum Abkanten von belichteten Druckplatten derart quer zur Ausgaberichtung angeordnet ist, dass die Vorderkante einer jeweiligen ausgegebenen Druckplatte abgekantet wird. Eine Weiterbildung kann sich dadurch auszeichnen, dass die abgekantete Druckplatte zu einem Folgemodul, z.B. einem Speichermodul, gefördert wird.

Eine Weiterbildung kann sich dadurch auszeichnen, dass das Belademodul oder eines der Belademodule oder das Abkantmodul eine Drehvorrichtung umfasst, welche als eine Vorrichtung zum Drehen der belichteten Druckplatten um eine zur Druckplattenebene senkrechte Achse (bevorzugt Vertikalachse) ausgebildet ist. Eine Weiterbildung kann sich dadurch auszeichnen, dass die Vorrichtung zum Abkanten von belichteten Druckplatten derart parallel zur Ausgaberichtung angeordnet ist, dass die Vorderkante einer jeweiligen ausgegebenen und um 90° gedrehten Druckplatte abgekantet wird.

Eine Weiterbildung kann sich dadurch auszeichnen, dass die um 90° gedrehte und abgekantete Druckplatte zu einem Folgemodul, z.B. einem Speichermodul, gefördert wird. Eine Weiterbildung kann sich dadurch auszeichnen, dass die um 90° gedrehte und abgekantete Druckplatte um 90° zurückgedreht wird und zu einem Folgemodul, z.B. einem Speichermodul, gefördert wird.

Eine Weiterbildung kann sich dadurch auszeichnen, dass das Belademodul oder eines der Belademodule eine Vorrichtung zum Trennen umfasst, welche Druckplatten von Zwischenlagepapier trennt.

Eine Weiterbildung kann sich dadurch auszeichnen, dass die Vorrichtung zum Bevorraten und Zuführen von unbelichteten Druckplatten für das Bevorraten einer Mehrzahl an Druckplatten ausgebildet ist, wobei die Druckplatten in wenigstens einer Kassette oder auf einer Palette bevorratet sind. Eine Weiterbildung kann sich dadurch auszeichnen, dass die Vorrichtung zum Bevorraten und Zuführen von unbelichteten Druckplatten eine Mehrzahl von prozesslosen Druckplatten bevorratet und einzeln zuführt.

Eine Weiterbildung kann sich dadurch auszeichnen, dass das Belichtungsmodul eine Stanzvorrichtung umfasst, welche als eine Vorrichtung zum Stanzen von Registerstanzungen in die Druckplatten ausgebildet ist.

Eine Weiterbildung kann sich dadurch auszeichnen, dass die Anlage wenigstens ein Speichermodul aufweist, welches eine Vorrichtung zum Speichern von belichteten und abgekanteten Druckplatten umfasst. Eine Weiterbildung kann sich dadurch auszeichnen, dass das Speichermodul eine Einschießvorrichtung umfasst, welche als Vorrichtung zum Streifeneinschießen zwischen gespeicherte Druckplatten ausgebildet ist. Eine Weiterbildung kann sich dadurch auszeichnen, dass die Anlage ein Sortiermodul aufweist, welches die belichteten und abgekanteten Druckplatten auf mehrere Speichermodule gemäß einer Sortiervorgabe verteilt.

Eine Weiterbildung kann sich dadurch auszeichnen, dass die Anlage folgende Module funktional aufeinander folgend umfasst: Belichtungsmodul, Kombimodul; oder Belichtungsmodul, Kombimodul, Speichermodul; oder Belichtungsmodul, Kombimodul, Sortiermodul, Speichermodul; oder Belademodul, Belichtungsmodul, Kombimodul, Speichermodul; oder Belademodul, Belichtungsmodul, Kombimodul, Sortiermodul, Speichermodul.

Eine Weiterbildung kann sich dadurch auszeichnen, dass die in der Anlage vorhandenen Module - außer die kombinierten Module des Kombimoduls - als separate Module ausgebildet sind, d.h. dass die Module z.B. voneinander getrennt platziert werden können (mit oder ohne Abstand).

Die in den obigen Abschnitten Technisches Gebiet, Erfindung und Weiterbildungen sowie im folgenden Abschnitt Ausführungsbeispiele offenbarten Merkmale und Merkmalskombinationen stellen - in beliebiger Kombination miteinander - weitere vorteilhafte Weiterbildungen der Erfindung dar.

### Ausführungsbeispiele zur Erfindung und Figuren

Die Figuren 1 bis 3 zeigen bevorzugte Ausführungsbeispiele der Erfindung und der Weiterbildungen. Einander entsprechende Merkmale sind in den Figuren mit denselben Bezugszeichen versehen. Sich in den Figuren wiederholende Bezugszeichen wurden der Übersichtlichkeit teils weggelassen.
Figur 1 zeigt eine schematische Darstellung einer Schnittansicht eines bevorzugen Ausführungsbeispiels einer erfindungsgemäßen Anlage.
Figur 2 zeigt eine schematische Darstellung einer Draufsicht eines bevorzugen Ausführungsbeispiels einer erfindungsgemäßen Anlage.
Figur 3 zeigt eine schematische Darstellung einer Draufsicht eines weiteren bevorzugen Ausführungsbeispiels einer erfindungsgemäßen Anlage.

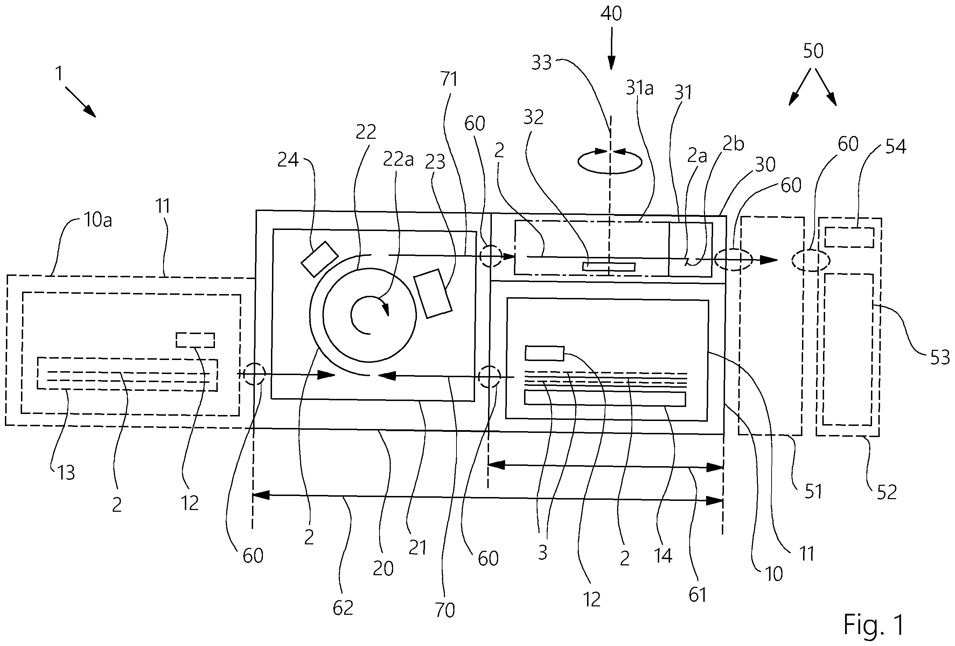

Figur 1 zeigt eine Anlage 1 zum Bereitstellen bzw. Erzeugen belichteter und abgekanteter Druckplatten 2. Jede Druckplatte 2 umfasst eine Vorderkante 2a, an welcher eine Abkantungen 2b (für das spätere Montieren der Druckplatte 2 auf einem Druckplattenzylinder) erzeugt wird. Die bevorrateten Druckplatten 2 sind zu deren Schutz vor Beschädigung durch Zwischenlagenpapiere 3 voneinander getrennt.

Die Anlage 1 umfasst wenigstens ein Belademodul 10, mit einer Vorrichtung 11 zum Bevorraten und Zuführen von unbelichteten Druckplatten 2 und mit einer Vorrichtung 12 zum Trennen und ggf. Entsorgen von Zwischenlagepapieren 3. Die Vorrichtung 11 kann eine Palette 14 mit den Druckplatten 2 aufnehmen. Alternativ können die Druckplatten 2 in einer Kassette oder in mehreren Kassetten bevorratet sein. Weiter alternativ kann die Vorrichtung 11 dazu ausgelegt sein, sowohl Paletten als auch Kassetten aufzunehmen.

Die Anlage 1 umfasst weiterhin ein Belichtungsmodul 20 ("Belichter") mit einer Vorrichtung 21 zum Belichten der vom Belademodul 10 zugeführten Druckplatten 2. Die Vorrichtung 21 umfasst bevorzugt einen Zylinder 22 zur Aufnahme der zu belichtenden Druckplatten 2 und zum Rotieren der Druckplatten 2 in eine Drehrichtung 22a während des Belichtens. Die Vorrichtung 21 umfasst weiterhin mindestens einen Belichtungskopf 23, welcher die Druckplatten 2 bevorzugt mit Laserlicht bebildert, und optional eine Stanzvorrichtung 24, welche die Druckplatten 2 mit Registerstanzungen 2c versieht. Dem Belichtungsmodul 20 werden die Druckplatten 2 in einer Zuführrichtung 70 (in der Figur z.B. von rechts) von dem Belademodul 10 zugeführt und das Belichtungsmodul 20 gibt die Druckplatten 2 in einer Ausgaberichtung 71 (in der Figur z.B. nach rechts) an das folgende Modul (siehe unten: Abkantmodul 30) ab; beide Richtungen können bevorzugt gegenläufig zueinander orientiert sein. Die Zufuhr kann dabei an einer Seite des Belichtungsmodul 20 unten und die Ausgabe oben erfolgen; ein Gehäuse des Belichtungsmodul 20 kann hierzu passende Öffnungen aufweisen. Die Zufuhr kann auch an einer Seite des Belichtungsmoduls 20 (in der Figur 1 z.B. von links) und die Ausgabe an der gegenüberliegenden Seite (in der Figur z.B. nach rechts) erfolgen. Die Zufuhr kann auch händisch erfolgen (in der Figur z.B. von rechts).

Die Anlage 1 umfasst weiterhin ein Abkantmodul 30 mit einer Vorrichtung 31 zum Abkanten von belichteten Druckplatten 2, d.h. zum Erzeugen einer jeweiligen Abkantung 2b. Die Vorrichtung 31 kann quer zu der Ausgaberichtung 71 des Belichtungsmodul 20 ausgerichtet sein; alternativ kann die Vorrichtung 31 längst zu der Ausgaberichtung 71 ausgerichtet sein (strichpunktierte Darstellung). Das Abkantmodul 30 kann weiterhin eine Drehvorrichtung 32 umfassen, welche die belichteten Druckplatten 2 um eine vertikale Drehachse 33 rotieren kann. Mittels der Drehvorrichtung 32 kann jeweils eine Druckplatte 2 z.B. um 90° gedreht werden, so dass deren Vorderkante 2a parallel zur jeweiligen Orientierung der Vorrichtung 31 ausgerichtet werden kann. Sofern das Belademodul 10 an seiner Oberseite bereits über eine Drehvorrichtung 32 verfügt, kann auch diese verwendet werden.

In Figur 1 ist deutlich erkennbar, dass das Abkantmodul 30 zusammen mit dem Belademodul 10 ein Kombimodul 40 bildet, insbesondere ist das Abkantmodul 30 auf dem Belademodul 10 angeordnet, z.B. auf das Belademodul 10 montiert und insbesondere auf diesem befestigt. Beide Module 10 und 30 beanspruchen auf diese Weise nur eine gemeinsame und daher verringerte Stellfläche 61 (im Vergleich zur Stellfläche einer Anlage 1 ohne Kombimodul, also mit nebeneinander angeordneten Belademodul 10 und Abkantmodul 30). Auch die Stellfläche 62 der Anlage 1 verringert sich auf diese Weise. Als Kombimodul 40 können beide Module 10 und 30 eine Einheit bilden, zum Beispiel ein gemeinsames Gestell und/oder gemeinsame Stellfüße aufweisen.

Die Anlage 1 umfasst weiterhin optional ein Folgemodul 50 oder mehrere Folgemodule 50, z.B. ein Sortiermodul 51 und/oder ein Speichermodul 52 mit einer Vorrichtung 53 zum Speichern von belichteten und abgekanteten Druckplatten 2. Das Sortiermodul 51 dient dabei dazu, Druckplatten 2 entsprechend der Druckaufträge bzw. der beteiligten Druckmaschinen zu sortieren. Das Speichermodul 52 dient dabei dazu, die bevorzugt bereits sortierten Druckplatten 2 aufzunehmen/zu speichern, um sie von dort zu den Druckmaschinen zu transportieren. Das Speichermodul 52 kann eine Einschießvorrichtung 54 umfassen, welche zum Beispiel Papierstreifen zwischen Druckplatten 2 unterschiedlicher Druckaufträge positionieren kann. Anstelle nur eines Speichermodules 52 kann bevorzugt auch eine Mehrzahl von Speichermodul und 52 vorgesehen sein; diese können zum Beispiel entlang des Sortiermoduls 51 angeordnet sein.

Die Anlage 1 umfasst weiterhin optional ein weiteres Belademodul 10a. Dieses ist bezüglich des Belademoduls 10 bevorzugt auf der gegenüberliegenden Seite des Belichtungsmodul 20 angeordnet. Auch das Belademodul 10a kann eine Vorrichtung 11 zum Bevorraten und Zuführen von Druckplatten 2 und eine Vorrichtung 12 zum Trennen von Zwischenlagepapieren 3 aufweisen. Das Belademodul 10a kann eine Kassette 13 oder mehrere solcher Kassetten zur Aufnahme unbelichteter Druckplatten 2 umfassen. Alternativ können die Druckplatten 2 auf einer Palette bevorratet sein. Weiter alternativ kann die Vorrichtung 11 dazu ausgelegt sein, sowohl Paletten als auch Kassetten aufzunehmen.

In Figur 1 ist ebenfalls deutlich erkennbar, dass eine zu verarbeitende Druckplatte 2 zwischen den Modulen der Anlage 1 übergeben werden muss. Hierzu weist die Anlage 1 Übergabepunkte oder Übergabevorrichtungen 60 (z.B. Rollen oder Bänder zum bevorzugt horizontalen Fördern der Druckplatten 2) auf, an denen die jeweiligen Übergabe zwischen einem Modul und einem Folgemodul erfolgt. Die Übergabepunkte 60 sind bevorzugt von geringer horizontaler Abmessung, sodass die Stellfläche 62 der Anlage 1 insgesamt möglichst gering bleibt

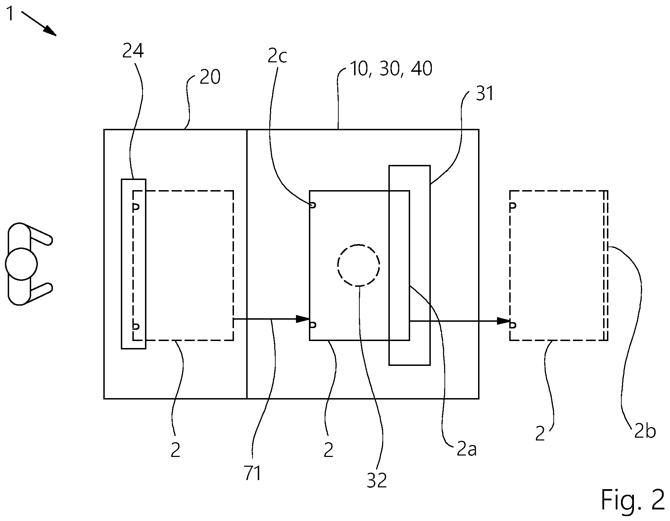

Figur 2 zeigt dieselbe Anlage 1 von oben, wobei nur das Kombimodul 40 (bestehend aus Belademodul 10 und Abkantmodul 30) und das Belichtungsmodul 20 gezeigt sind. Es ist erkennbar, dass eine belichtete Druckplatte 2 von dem Belichtungsmodul 20 in Ausgaberichtung 71 an das Abkantmodul 30 übergeben wird und nach dem Abkanten in derselben Richtung 71 ausgegeben oder an einem Folgemodul 50 übergeben wird. Die Drehvorrichtung 32 kommt dabei nicht zum Einsatz, d.h. gegebenenfalls kann auf sie in dieser Ausführungsform verzichtet werden. Daher wird die Abkantung 2b an der Vorderkante 2a der Druckplatte 2 quer zur Ausgaberichtung 71 erzeugt.

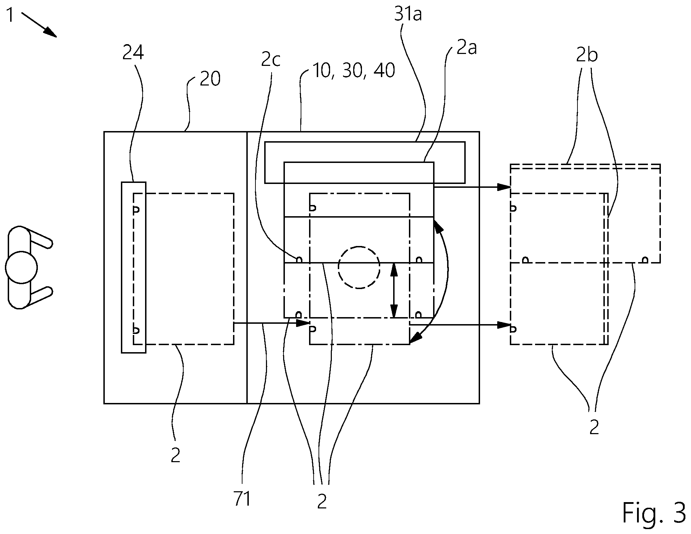

Figur 3 zeigt im Vergleich zur Figur 2 eine Anlage 1, welche den entsprechenden Vorgang des Abkantens unter Einsatz der Drehvorrichtung 32 ausführt. Wieder wird eine belichtete Druckplatte 2 von dem Belichtungsmodul 20 in Ausgaberichtung 71 an das Abkantmodul 30 übergeben. Dort wird die Druckplatte 2 jedoch unter Einsatz der Drehvorrichtung 32 um 90° gedreht und auf diese Weise die Vorderkante 2a der Druckplatte 2 parallel zur Vorrichtung 31a zum Abkanten von Druckplatten 2 ausgerichtet. Nach dem Abkanten kann die Druckplatte 2 in der bestehenden Ausrichtung ausgegeben oder an ein Folgemodul übergeben werden; alternativ kann die Druckplatte 2 um 90° zurückgedreht werden und erst dann ausgegeben oder an ein Folgemodul übergeben werden (beide Alternativen sind überlagert dargestellt).

Ein Vergleich der beiden Figuren 2 und 3 lässt erkennen, dass in der jeweils gezeigten Anlage 1 das Abkantmodul entweder parallel zur Ausgaberichtung 71 oder quer zur Ausgaberichtung 71 angeordnet ist. Um die belichtete und abzukantende Druckplatte 2 durch das Abkantmodul 30 oder in dem Abkantmodul 30 zu fördern, können im Abkantmodul 30 z.B. entsprechende Transportrollen oder Transportbänder vorgesehen sein.

### Bezugszeichenliste

- 1: Anlage
- 2: Druckplatte/-n
- 2a: Vorderkante der Druckplatte
- 2b: Abkantung
- 2c: Registerstanzungen
- 3: Zwischenlagepapier
- 10: Belademodul
- 10a: weiteres Belademodul
- 11: Vorrichtung zum Bevorraten und Zuführen von Druckplatten
- 12: Vorrichtung zum Trennen von Zwischenlagepapier
- 13: Kassette
- 14: Palette
- 20: Belichtungsmodul
- 21: Vorrichtung zum Belichten von Druckplatten
- 22: Zylinder
- 22a: Drehrichtung
- 23: Belichtungskopf
- 24: Stanzvorrichtung
- 30: Abkantmodul
- 31: Vorrichtung zum Abkanten von Druckplatten, in Querrichtung
- 31a: Vorrichtung zum Abkanten von Druckplatten, alternativ in Längsrichtung
- 32: Drehvorrichtung
- 33: vertikale Drehachse
- 40: Kombimodul
- 50: Folgemodul/-e
- 51: Sortiermodul
- 52: Speichermodul/-e
- 53: Vorrichtung zum Speichern von Druckplatten
- 54: Einschießvorrichtung
- 60: Übergabepunkt/-e, Übergabevorrichtung/-en
- 61: Stellfläche des Kombimoduls
- 62: Stellfläche der Anlage
- 70: Zuführrichtung
- 71: Ausgaberichtung

## Patentansprüche

1. Anlage zum Bereitstellen belichteter und abgekanteter Druckplatten, welche folgende Module aufweist: wenigstes ein Belademodul (10), welches eine Vorrichtung (11) zum Bevorraten und Zuführen von unbelichteten Druckplatten (2) umfasst; ein Belichtungsmodul (20), welches eine Vorrichtung (21) zum Belichten von zugeführten Druckplatten (2) umfasst; und ein Abkantmodul (30), welches eine Vorrichtung (31) zum Abkanten von belichteten Druckplatten (2) umfasst,
**dadurch gekennzeichnet,**
**dass** das Abkantmodul (30) und das Belademodul (10) oder eines der Belademodule (10) derart zu einem Kombimodul (40) zusammengefasst sind, dass die Vorrichtung (31) zum Abkanten von belichteten Druckplatten (2) auf der Vorrichtung (11) zum Bevorraten und Zuführen von unbelichteten Druckplatten (2) angeordnet ist.

2. Anlage nach Anspruch 1,
**dadurch gekennzeichnet,**
**dass** die unbelichteten Druckplatten (2) dem Belichtungsmodul (20) von dem Belademodul (10) in einer Zuführrichtung (70) zugeführt werden.

3. Anlage nach Anspruch 2,
**dadurch gekennzeichnet,**
**dass** die belichteten Druckplatten (2) von dem Belichtungsmodul (20) in einer Ausgaberichtung (71) ausgegeben werden.

4. Anlage nach Anspruch 3,
**dadurch gekennzeichnet,**
**dass** die Ausgaberichtung (71) entgegen der Zuführrichtung (70) orientiert ist.

5. Anlage nach einem der vorhergehenden Ansprüche 3 oder 4,
**dadurch gekennzeichnet,**
**dass** die Vorrichtung (31) zum Abkanten von belichteten Druckplatten (2) derart quer zur Ausgaberichtung (71) angeordnet ist, dass die Vorderkante (2a) einer jeweiligen ausgegebenen Druckplatte (2) abgekantet wird.

6. Anlage nach einem der vorhergehenden Ansprüche,
**dadurch gekennzeichnet,**
**dass** das Belademodul (10) oder eines der Belademodule (10) oder das Abkantmodul (30) eine Drehvorrichtung (32) umfasst, welche als eine Vorrichtung (32) zum Drehen der belichteten Druckplatten (2) um eine zur Druckplattenebene senkrechte Achse (33) ausgebildet ist.

7. Anlage nach einem der vorhergehenden Ansprüche 3 bis 6,
**dadurch gekennzeichnet,**
**dass** die Vorrichtung (31) zum Abkanten von belichteten Druckplatten (2) derart parallel zur Ausgaberichtung (71) angeordnet ist, dass die Vorderkante (2a) einer jeweiligen ausgegebenen und um 90° gedrehten Druckplatte (2) abgekantet wird.

8. Anlage nach Anspruch 7,
**dadurch gekennzeichnet,**
**dass** die um 90° gedrehte und abgekantete Druckplatte (2) zu einem Folgemodul (50) gefördert wird.

9. Anlage nach Anspruch 7,
**dadurch gekennzeichnet,**
**dass** die um 90° gedrehte und abgekantete Druckplatte (2) um 90° zurückgedreht wird und zu einem Folgemodul (50) gefördert wird.

10. Anlage nach einem der vorhergehenden Ansprüche,
**dadurch gekennzeichnet,**
**dass** die Vorrichtung (11) zum Bevorraten und Zuführen von unbelichteten Druckplatten (2) eine Mehrzahl von prozesslosen Druckplatten (2) bevorratet und einzeln zuführt.

11. Anlage nach einem der vorhergehenden Ansprüche,
**dadurch gekennzeichnet,**
**dass** die Anlage (1) wenigstens ein Speichermodul (52) aufweist, welches eine Vorrichtung (53) zum Speichern von belichteten und abgekanteten Druckplatten (2) umfasst.

12. Anlage nach einem der vorhergehenden Ansprüche,
**dadurch gekennzeichnet,**
**dass** die Anlage (1) ein Sortiermodul (52) aufweist, welches die belichteten und abgekanteten Druckplatten (2) auf mehrere Speichermodule (52) gemäß einer Sortiervorgabe verteilt.

13. Anlage nach einem der vorhergehenden Ansprüche,
**dadurch gekennzeichnet,**
**dass** die Anlage (1) folgende Module funktional aufeinander folgend umfasst:
Belichtungsmodul (20), Kombimodul (40); oder
Belichtungsmodul (20), Kombimodul (40), Speichermodul (52); oder
Belichtungsmodul (20), Kombimodul (40), Sortiermodul (51), Speichermodul (52); oder
Belademodul (10), Belichtungsmodul (20), Kombimodul (40), Speichermodul (52); oder
Belademodul (10), Belichtungsmodul (20), Kombimodul (40), Sortiermodul (51), Speichermodul (52).
